Europäisches Patentamt

European Patent Office

Office européen des brevets

(11) Veröffentlichungsnummer: **0 032 359**
**B1**

(12) **EUROPÄISCHE PATENTSCHRIFT**

(45) Veröffentlichungstag der Patentschrift:
08.08.84

(21) Anmeldenummer: 80810399.8

(22) Anmeldetag: 17.12.80

(51) Int. Cl.³: **G 04 G 3/02**, H 03 L 1/02,
G 04 F 5/06

(54) Oszillator mit digitaler Temperaturkompensation.

(30) Priorität: 10.01.80 CH 158/80

(43) Veröffentlichungstag der Anmeldung:
22.07.81 Patentblatt 81/29

(45) Bekanntmachung des Hinweises auf die Patenterteilung:
08.08.84 Patentblatt 84/32

(84) Benannte Vertragsstaaten:
DE FR GB

(56) Entgegenhaltungen:
EP - A - 0 015 873
EP - A - 0 019 591
CH - A - 453 223
GB - A - 2 004 155
US - A - 4 071 797

ELECTRONICS LETTERS, Band 11, Nr. 14, 10.Juli 1975,
Seiten 304,305, J. BRUNNER: "Wide-range temperature
compensation by addition of two crystal-resonator
frequencies: practical results with quartz and LiTaO3"
JAHRBUCH DER DEUTSCHEN GESELLSCHAFT FÜR
CHRONOMETRIE E.V., Band 28, 1977, Seiten 9-15,
Stuttgart, DE, H. EFFENBERGER: "Digitale
Temperaturkompensation von
Schwingquartzoszillatoren mit automatischem
Frequenzabgleich"

(73) Patentinhaber: SOCIETE SUISSE POUR L'INDUSTRIE
HORLOGERE MANAGEMENT SERVICES S.A., Rue
Stämpfli 96, CH-2500 Bienne (CH)

(72) Erfinder: Zumsteg, Alphonse, St. Niklausstrasse 24,
CH-4500 Solothurn (CH)

(74) Vertreter: Seehof, Michel et al, c/o AMMANN
PATENTANWAELTE AG BERN Schwarztorstrasse 31,
CH-3001 Bern (CH)

## Beschreibung

Die vorliegende Erfindung bezieht sich auf eine Oszillatorschaltung mit zwei Quarzoszillatoren mit unterschiedlicher parabolischer Temperaturcharakteristik, jedoch gleicher Inversionstemperatur, einem eingangsseitig an die Ausgänge der Quarzoszillatoren angeschlossenen Differenzfrequenzgenerator zur Erzeugung eines Ausgangssignals mit einer der Frequenzdifferenz der Oszillatorsignale entsprechenden Frequenz, einer Korrekturschaltung zur Erzeugung eines Korrektursignals durch Multiplikation der Frequenz des Ausgangssignals des Differenzfrequenzgenerators mit einem Faktor, der so gewählt ist, daß die Frequenz des bei Überlagerung des Signals des einen Quarzoszillators mit dem Korrektursignal erhaltenen Signals temperaturunabhängig ist, einer Frequenzteilerkette, in der die Überlagerung des Signals des einen Quarzoszillators mit dem Korrektursignal durchgeführt wird.

Eine solche Oszillatorschaltung wird in der GB-A- 20 045 115 beschrieben, wobei zwei Niederfrequenz-Quarzoszillatoren mit der für Uhrenschaltungen üblichen Frequenz von 32 kHz verwendet werden. Bekanntlich sind jedoch solche Niederfrequenz-Quarzoszillatoren einer beträchtlichen Alterung unterworfen, die längerfristig die durch die Temperaturkompensation erzielte Verbesserung herabsetzt. Außerdem ist deren Genauigkeit durch die Frequenz begrenzt.

In der zum Stand der Technik gemäß Art. 54(3) EPÜ gehörenden Druckschrift EP-A-0 019 591 des gleichen Anmelders ist eine Oszillatorschaltung mit Temperaturkompensation angegeben, die einen Hochfrequenz- und einen Niederfrequenzquarzoszillator aufweist, wobei beide Oszillatoren verschiedene Inversionstemperaturen besitzen und diese Schaltung somit auf einem von der eingangs erwähnten Schaltung verschiedenen Funktionsprinzip basiert.

In der ebenfalls zum Stand der Technik gemäß Art. 54(3) bildenden Druckschrift EP-A-0 015 873 desselben Anmelders ist eine Schaltung beschrieben, die ebenfalls einen Niederfrequenz- und einen Hochfrequenzoszillator aufweist, wobei der Hochfrequenzoszillator zwecks Stromersparnis nur zeitweilig angeschaltet ist. Die Temperaturkompensation für diese Schaltung ist nur summarisch beschrieben, insbesondere fehlt eine nähere Angabe zur Funktion der Korrekturschaltung.

Es ist Aufgabe der vorliegenden Erfindung eine Oszillatorschaltung mit digitaler Temperaturkompensation anzugeben, die insbesondere gegenüber der erstgenannten Oszillatorschaltung einer geringeren Alterung unterworfen ist und eine erhöhte Genauigkeit aufweist.

Diese Aufgabe wird durch die im Anspruch 1 definierte Oszillatorschaltung gelöst.

Die Erfindung wird nun im Einzelnen anhand eines Ausführungsbeispiels und einer Zeichnung näher erläutert.

Fig. 1 zeigt das parabolische Temperaturverhalten eines Hoch- und eines Niederfrequenzresonators in einer bestimmten Einstellung und

Fig. 2 zeigt eine Blockschaltung eines erfindungsgemäßen Oszillators.

Bei der Temperaturkompensation sollte die Korrektur möglichst klein sein, denn je geringer die Korrektur ist, desto kleiner muß die Genauigkeit dieser Korrektur sein. Man muß daher nach Oszillatoren suchen, deren Frequenzabweichungen gering sind, wie zum Beispiel solche mit Hochfrequenz-Quarzresonatoren gemäß US-A-4 071 797.

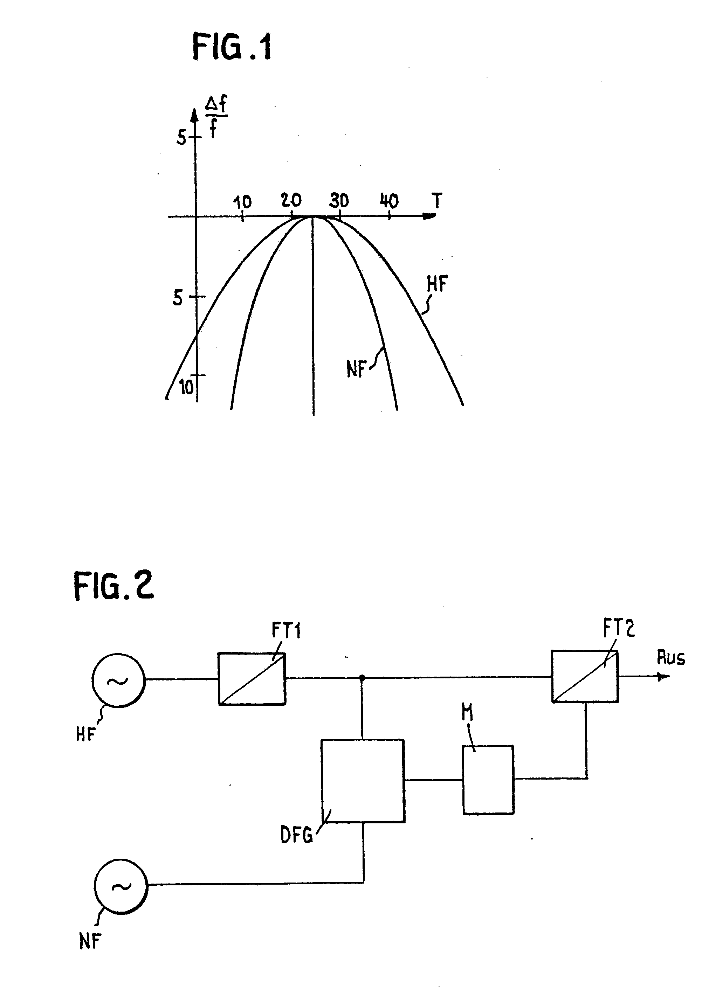

In Fig. 1 ist das parabolische Temperaturverhalten des oben erwähnten Hochfrequenzresonators nach Teilung von 4,2 MHz auf 32 kHz und das parabolische Temperaturverhalten eines herkömmlichen Niederfrequenzresonators mit einer Frequenz von 32 kHz dargestellt.

Dabei gilt:

$$f_1\,(T) = f_{10}\,(1 + \beta_1(T-T_1)^2 + \gamma\,(T-T_1)^3)$$

und

$$f_2\,(T) = f_{20}\,(1 + \beta_2(T-T_2)^2),$$

wobei $f_{10}$ die Frequenz nach Teilung auf 32 kHz ist und $T_1$, $T_2$ die Inversionstemperaturen und $\beta_1 = -1{,}2 \cdot 10^{-8}/(^\circ C)^2$ der quadratische oder parabolische Temperaturkoeffizient für den Hochfrequenzresonator und $\beta_2 = -3{,}6 \cdot 10^{-8}/(^\circ C)^2$ der parabolische Temperaturkoeffizient des Niederfrequenzquarzes sind und $\gamma$ der kubische Temperaturkoeffizient ist.

Für die nachfolgende Beispielsangabe wird der Einfluß von $\gamma$ vernachlässigt.

Um die erfindungsgemäße Temperaturkompensation durchzuführen, werden die Resonatoren derart ausgewählt, daß die Temperaturinversionspunkte beider Parabeln dieselben sind ($T_1 = T_2 = T_0$).

Bei einem Ausführungsbeispiel des erfindungsgemäßen Oszillators wird nach dem Blockschema der Fig. 2 die Frequenz von 4,2 MHz des Hochfrequenzresonators HF auf die gleiche Frequenz von 32 kHz des Niederfrequenzresonators NF, der ein Stimmgabelquarz ist, unterteilt. Das unterteilte Signal und dasjenige des Niederfrequenzresonators werden einem digitalen Differenzfrequenzgenerator DFG eingespeist.

Gemäß der Gleichung für die Korrekturfrequenz f(T)

$$f\,(T) = f_{10}\,(1 + \beta_1(T-T_0)^2) + k\,f_{10}(T-T_0)^2\,(\beta_1 - \beta_2))$$

errechnet sich k zu

$$k = \frac{\beta_1}{\beta_2 - \beta_1}$$

welcher Wert in der Korrekturschaltung M benutzt wird und beispielsweise in einem PROM gespeichert werden kann. Nach der Multiplikation der Differenzfrequenz mit k in der Korrekturschaltung wird das so erhaltene Korrektursignal an geeigneter Stelle der Frequenzteilerkette FT2 eingegeben, in welcher die Frequenz auf 1 Hz unterteilt und gleichzeitig korrigiert wird. Das Ausgangssignal AUS wird dann der Zeitmeßschaltung, beziehungsweise dem Schrittschaltmotor zugeführt.

Der vorgehend beschriebene Oszillator kann besonders vorteilhaft dort eingesetzt werden, wo hohe Genauigkeit und ein günstiges Temperatur- und Langzeitverhalten erwünscht ist, und wo das verfügbare Volumen klein ist. Dies trifft beispielsweise bei einer Armbanduhr oder bei einer Filmkamera zu.

## Patentansprüche

1. Oszillatorschaltung mit zwei Quarzoszillatoren (NF; HF, FT1) mit unterschiedlicher parabolischer Temperaturcharakteristik, jedoch gleicher Inversionstemperatur, einem eingangsseitig an die Ausgänge der Quarzoszillatoren angeschlossenen Differenzfrequenzgenerator (DFG) zur Erzeugung eines Ausgangssignals mit einer der Frequenzdifferenz der Oszillatorsignale entsprechenden Frequenz, einer Korrekturschaltung (M), zur Erzeugung eines Korrektursignals durch Multiplikation der Frequenz des Ausgangssignals des Differenzfrequenzgenerators mit einem Faktor (k), der so gewählt ist, daß die Frequenz des bei Überlagerung des Signals des einen Quarzoszillators (HF, FT1) mit dem Korrektursignal erhaltenen Signals temperaturunabhängig ist, einer Frequenzteilerkette (FT2), in der die Überlagerung des Signals des einen Quarzoszillators (HF, FT1) mit dem Korrektursignal durchgeführt wird, dadurch gekennzeichnet, daß der eine Quarzoszillator aus einem Hochfrequenzoszillator (HF) mit einem Hochfrequenz-Quarzresonator und einem diesem nachgeschalteten Frequenzteiler (FT1) besteht, der die Frequenz des Ausgangssignals des Hochfrequenzoszillators auf die Frequenz des Ausgangssignals des anderen Quarzoszillators teilt und daß der andere der beiden Quarzoszillatoren ein Niederfrequenzoszillator (NF) mit einem Niederfrequenz-Quarzresonator ist.

2. Oszillatorschaltung nach Anspruch 1, dadurch gekennzeichnet, daß der Faktor (k) in einem PROM gespeichert ist.

3. Oszillatorschaltung nach Anspruch 1, dadurch gekennzeichnet, daß der Hochfrequenzoszillator eine Frequenz von 4,2 MHz besitzt und der Niederfrequenzoszillator (NF) ein Stimmgabelquarz mit einer Frequenz von 32 kHz ist.

## Claims

1. An oscillator circuit with two quartz oscillators (NF; HF, FT1) having different parabolic temperature characteristics but the same temperature of inversion, a beat frequency generator (DFG) connected to the outputs of the quartz oscillators for producing an output signal with a frequency corresponding to the frequency beat of the signals of the oscillators, a correction circuit (M) for producing a correction signal by multiplying the frequency of the output signal of the beat frequency generator with a factor (k) which is choosen such that the frequency of the signal obtained by the superposition of the signal of one of the quartz oscillators (HF, FT1) and the correction signal is independent on the temperature, a chain of frequency dividers (FT2) in which the superposition of the signal of one of the oscillators (HF, FT1) with the correction signal is performed, characterized in that a quartz oscillator consists of a high frequency oscillator (HF) with a high frequency quartz resonator followed by a frequency divider (FT1) which divides the frequency of the output signal of the high frequency oscillator to the frequency of the output signal of the other oscillator, and in that the other quartz oscillator is a low frequency oscillator (NF) with a low frequency quartz resonator.

2. Oscillator circuit according to claim 1, characterized in that the factor (k) is memorized in a PROM.

3. Oscillator circuit according to claim 1, characterized in that the high frequency generator has a frequency of 4.2 MHz and in that the low frequency oscillator (NF) has a tuning fork quartz resonator of a frequency of 32 kHz.

## Revendications

1. Circuit oscillateur avec deux oscillateurs à quartz (NF; HF, FT1) avec une caractéristique de température parabolique différente mais une même température d'inversion, un générateur de différence de fréquences (DFG) connecté aux sorties des oscillateurs à quartz pour produire un signal de sortie avec une fréquence correspondant à la différence de fréquence des signaux des oscillateurs, un circuit de correction (M) pour produire un signal de correction par multiplication de la fréquence du signal de sortie du générateur de différence de fréquences avec un facteur (k) choisi de manière que la fréquence du signal obtenu par la superposition du signal de l'un des oscillateurs à quartz (HF, FT1) avec le signal de correction est indépendante de la température, une chaine de diviseurs de fréquence (FT2) dans laquelle la superposition du signal de l'un des oscillateurs à quartz (HF, FT1) avec le signal de correction est exécutée, caractérisé en ce qu'un oscillateur à quartz consiste en un oscillateur haute fréquence (HF) avec un résonateur à quartz haute fréquence suivi d'un diviseur de fréquence (FT1) qui divise la fréquence du signal de sortie de l'oscillateur haute fréquence à la fréquence su signal de sortie de l'autre oscillateur, et en ce que l'autre oscillateur à quartz est un oscillateur basse fréquence (NF) avec un résonateur à quartz basse fréquence.

2. Circuit oscillateur selon la revendication 1, caractérisé en ce que le facteur (k) est mémorisé dans une PROM.

3. Circuit oscillateur selon la revendication 1, caractérisé en ce que l'oscillateur haute fréquence a une fréquence de 4,2 MHz et que l'oscillateur basse fréquence (NF) a un quartz à diapason d'une fréquence de 32 kHz.

# FIG.1

# FIG.2